# EUROPÄISCHE PATENTSCHRIFT

(11) **EP 0 757 852 B1**
(45) Veröffentlichungstag und Bekanntmachung des Hinweises auf die Patenterteilung: **11.08.1999**
(21) Anmeldenummer: 96903988.2
(22) Anmeldetag: 06.02.1996
(51) Int. Cl.: H02B 1/30, H05K 7/18

(54) **SCHALTSCHRANK MIT RAHMENGESTELL UND TÜRELEMENTEN**
SWITCHGEAR CABINET WITH A FRAME AND DOOR ELEMENTS
ARMOIRE DE DISTRIBUTION MUNIE D'UNE OSSATURE ET D'ELEMENTS DE PORTE

(30) Priorität: 27.02.1995 DE 19506744
(43) Veröffentlichungstag der Anmeldung: 12.02.1997
(73) Patentinhaber: Rittal-Werk Rudolf Loh GmbH & Co. KG, 35745 Herborn (DE)
(72) Erfinder: BESSERER, Horst, D-35745 Herborn (DE); MÜNCH, Udo, D-35764 Sinn (DE); NEUHOF, Markus, D-35630 Ehringshausen-Niederlemp (DE); NICOLAI, Walter, D-35418 Buseck (DE); PAWLOWSKI, Adam, D-35713 Eschenburg-Wissenbach (DE); SCHÜLER, Matthias, D-35716 Dietzhölztal (DE); STRACKBEIN, Heinrich, D-35444 Biebertal (DE)
(74) Vertreter: Fleck, Hermann-Josef, Dr.-Ing.
(86) Internationale Anmeldenummer: EP9600473
(87) Internationale Veröffentlichungsnummer: WO9627228

(56) Entgegenhaltungen:
- EP-A- 0 533 555
- EP-A- 0 630 088
- WO-A-93/09697
- DE-A- 1 910 658
- DE-A- 4 336 188
- FR-A- 2 681 403

## Beschreibung

Die Erfindung betrifft einen Schaltschrank mit Türelementen, bei dem die Türelemente mittels Scharnierelementen und Verschlußelementen an zwei benachbarten Seiten anlenkbar, verschließbar und wieder freigebbar sind, wobei die Seiten symmetrisch zur Mitte ihrer Längsabmessung mindestens zwei hülsenförmige Anschlußelemente tragen, die sowohl als Scharnierelement als auch als Verschlußelement verwendbar sind, und wobei die Türelemente auf ihren Innenseiten symmetrisch zur Mittelachse auf der Anlenkseite jeweils auf die Anschlußelemente ausgerichtete Scharnierelemente für Scharnierbolzen und auf der Schließseite jeweils auf die Anschlußelemente ausgerichtete Gegenschließelemente aufweisen.

Ein Schaltschrank dieser Art ist aus der CH 487 575 bekannt (siehe auch DE 1910658 A). Bei diesem bekannten Schaltschrank sind die Türelemente mittels Scharnierelementen und Verschlußelementen an zwei benachbarten, vertikalen Seiten anlenkbar, verschließbar und wieder freigebbar. Die Seiten sind symmetrisch zur Mitte ihrer Längsabmessung mit mindestens zwei hülsenförmigen Anschlußelementen versehen, die sowohl als Scharnierelement als auch als Schließelement verwendbar sind. Die Türelemente tragen auf ihren Innenseiten ebenfalls symmetrisch zur horizontalen Mittelachse auf der Anlenkseite jeweils auf die Anschlußelemente ausgerichtete Scharnierelemente für Scharnierbolzen und auf der Schließseite jeweils auf die Anschlußelemente ausgerichtete Gegenschließelemente.

Bei diesem bekannten Schaltschrank verschließt ein Türelement die gesamte Vorder- oder Rückseite. Das Türelement ist dabei links oder rechts anschlagbar. Es ist aber nicht möglich, das Türelement wahlweise an einer von zwei vertikalen, senkrecht zueinander stehenden Seiten des Schaltschrankes anzubringen. Außerdem ist der Schaltschrank nicht dafür geeignet, eine Seite desselben mittels zweier Türelemente zu verschließen.

Aus der EP 0 533 555 A ist ein Profilabschnitt für den Rahmen eines Schaltschranks bekannt. Der Schrank selbst ist in der verwandten FR 2 681 403 A abgebildet. Die Außenkante des Profilabschnitts gemäß EP '555 bildet mittels eines geneigten Profileckabschnitts einen freien Außenbereich, an dem Anschlußelemente angebracht werden, welche sowohl ein Scharnierelement als auch ein Verschlußelement aufnehmen können.

Es ist Aufgabe der Erfindung, einen Schaltschrank der eingangs erwähnten Art so auszubilden, daß wahlweise jede Seite des Schaltschrankes mit einem über die gesamte Höhe reichenden Türelement oder mit zwei über jeweils die halbe Höhe reichenden Türelementen zu verschließen.

Diese Aufgabe wird nach der Erfindung dadurch gelöst, daß der Schaltschrank ein aus Rahmenschenkeln zusammengesetztes Rahmengestell aufweist, daß die Außenkanten der Rahmenschenkel mittels geneigter Profileckabschnitte freie Außeneckbereiche bilden, daß die Profileckbereiche im stumpfen Winkel zu den aufeinanderstoßenden Außenseiten-Profilabschnitten der Rahmenschenkel stehen, daß an den geneigten Profileckabschnitten aller vertikalen Rahmenschenkel symmetrisch zur horizontalen Mittelebene des Schaltschrankes Paare von Anschlußelementen angebracht sind, und daß die beiden Anschlußelemente der Paare jeweils wieder symmetrisch zu den Mittelebenen der oberen und unteren Schrankhälfte an den vertikalen Rahmenschenkel angeordnet sind.

Mit dieser Anordnung von zwei Paaren von Anschlußelementen an einem vertikalen Rahmenschenkel ist es möglich, jede Seite des Schaltschrankes für das Anbringen eines Türelementes zu verwenden. Außerdem können auch zwei einander gegenüberliegende Seiten des Schaltschrankes mit Türelementen verschlossen werden. Außerdem können in jedem Falle statt einem über die gesamte Höhe des Schaltschrankes reichenden Türelement auch zwei Türelemente zum Verschließen der oberen und der unteren Schrankhälfte verwendet werden.

Die Verteilung der Anschlußelemente an einen vertikalen Rahmenschenkel ist vorzugsweise so gewählt, daß die hülsenförmigen Anschlußelemente der vertikalen Rahmenschenkel eine axiale Abmessung aufweisen und in einem Abstand von der oberen und unteren Seite des Schaltschrankes und der horizontalen Mittelebene des Schaltschrankes angebracht sind.

Für die Anlenkung eines Türelementes ist nach einer Ausgestaltung vorgesehen, daß die Scharnierelemente an den Türelementen als axial beabstandete Doppelhülsen ausgebildet sind, deren Aufnahmen für Scharnierbolzen den Aufnahmen der als Anschlußelemente dienenden Hülsen der Vertikalen Rahmenschenkel entsprechen und zwischen den beiden Hülsen der Scharnierelemente ein Anschlußelement eines vertikalen Rahmenschenkels aufnehmen. Die Anlenkung kann jedoch auch so ausgeführt sein, daß die Scharnierelemente eines Türelementes als Hülsen ausgebildet sind, die sich an die einander zugekehrten oder abgekehrten Stirnseiten der beiden als Hülsen ausgebildeten Anschlußelemente eines vertikalen Rahmenschenkel anschließen und Aufnahmen für Scharnierbolzen bilden, die den Aufnahmen der Anschlußelemente der vertikalen Rahmenschenkel entsprechen.

Für die Schließung des Türelementes an einem vertikalen Rahmenschenkel ist nach einer Ausgestaltung vorgesehen, daß die Gegenschließelemente der Türelemente als Verschlußbolzen ausgebildet sind, die in auf der Innenseite des Türelemente festgelegten Hülsen verstellbar geführt und in die als Schließaufnahmen dienenden Anschlußelemente der vertikalen Rahmenschenkel einführbar und aus diesem wieder herausführbar sind. Dabei ist vorteilhafterweise die Ausbildung so, daß die als Verschlußbolzen ausgebildeten Gegenschließelemente Teile von Schubstangen eines Schubstangenverschlusses und mittels eines Schubstangenschlosses gegenläufig verstellbar sind.

Ein ausreichend großer Raum im Außeneckbereich der Rahmenschenkel wird dadurch geschaffen, daß die Profileckabschnitte der Rahmenschenkel im Winkel von 135° zu den beiden aufeinanderstoßenden, senkrecht zueinander stehenden Außenseiten-Profilabschnitten stehen und daß die Rahmenschenkel vorzugsweise als offene oder geschlossene Hohlprofilabschnitte ausgebildet sind, wobei zudem noch vorgesehen sein kann, daß die Profileckabschnitte der Rahmenschenkel mittels Übergangsabschnitten in die Außenseiten-Profilabschnitte übergehen, wobei die Übergangsabschnitte vorzugsweise senkrecht zu den Außenseiten-Profilabschnitten stehen.

Ein bündiger Abschluß des Schaltschrankes in den vertikalen Außeneckbereichen wird dadurch erreicht, daß die Anschlußelemente der vertikalen Rahmenschenkel bündig mit den Außenseiten-Profilabschnitten abschließen. Dann ist beim Verschließen des Türelementes erreicht, daß die Türelemente mit einem abgekanteten Rand versehen sind, und daß die Scharnierelemente und die Gegenschließelemente der Türelemente in den freien Außeneckbereichen der vertikalen Rahmenschenkel angeordnet oder daran aufgenommen werden.

Bei einem Türelement, das sich über die gesamte Höhe des Schaltschrankes erstreckt, ist für die Scharnierseite vorgesehen, daß das Türelement sich über die gesamte Höhe des Schaltschrankes erstreckt und auf der Scharnierseite auf die beiden Paare von Anschlußelementen der vertikalen Rahmenschenkel ausgerichtete scharnierelemente trägt, während auf der Schließseite die Ausgestaltung so vorgenommen ist, daß die Anschlußelemente eines der Schließseite des Türelementes zugekehrten, vertikalen Rahmenschenkels paarweise als Aufnahmen für die Schubstangen von zwei Schubstangenverschlüssen verwendet sind, wobei der eine Schubstangenverschluß dem oberen Paar von Anschlußelementen und der andere Schubstangenverschluß dem unteren Paar von Anschlußelementen zugeordnet sind.

Bei einem Türelement, das sich nur über die halbe Höhe des Schaltschrankes erstreckt und die obere oder untere Schrankhälfte verschließen soll, ist dagegen vorgesehen, daß die Türelemente sich über die obere und untere Hälfte der Höhe des Schaltschrankes erstrecken und die auf die oberen Paare von Anschlußelemente sowie die unteren Paare benachbarter, vertikaler Rahmenschenkel ausgerichteten Schließelemente und Scharnierelemente sowie einen Schubstangenverschluß tragen.

Die Erfindung wird anhand von verschiedenen, in den Zeichnungen dargestellten Ausführungsbeispielen näher erläutert. Es zeigen:
- Fig. 1: in perspektivischer Ansicht ein Rahmengestell für einen Schaltschrank, desen vertikale Rahmenschenkel mit Anschlußelementen versehen sind,
- Fig. 2: eine perspektivische Teilansicht des Bereiches II der Fig. 1,
- Fig. 3: in Teilansicht und Draufsicht schematisch die Anlenkung eines Türelementes an einem vertikalen Rahmenschenkel,
- Fig. 4: die Ansicht auf die Innenseite eines Türelementes, das sich über die gesamte Höhe des Schaltschrankes erstreckt, und
- Fig. 5: die Ansicht auf die Innenseite eines Türelementes, das sich nur über die halbe Höhe des Schaltschrankes erstreckt und die obere oder die untere Hälfte des Schaltschrankes verschließt.

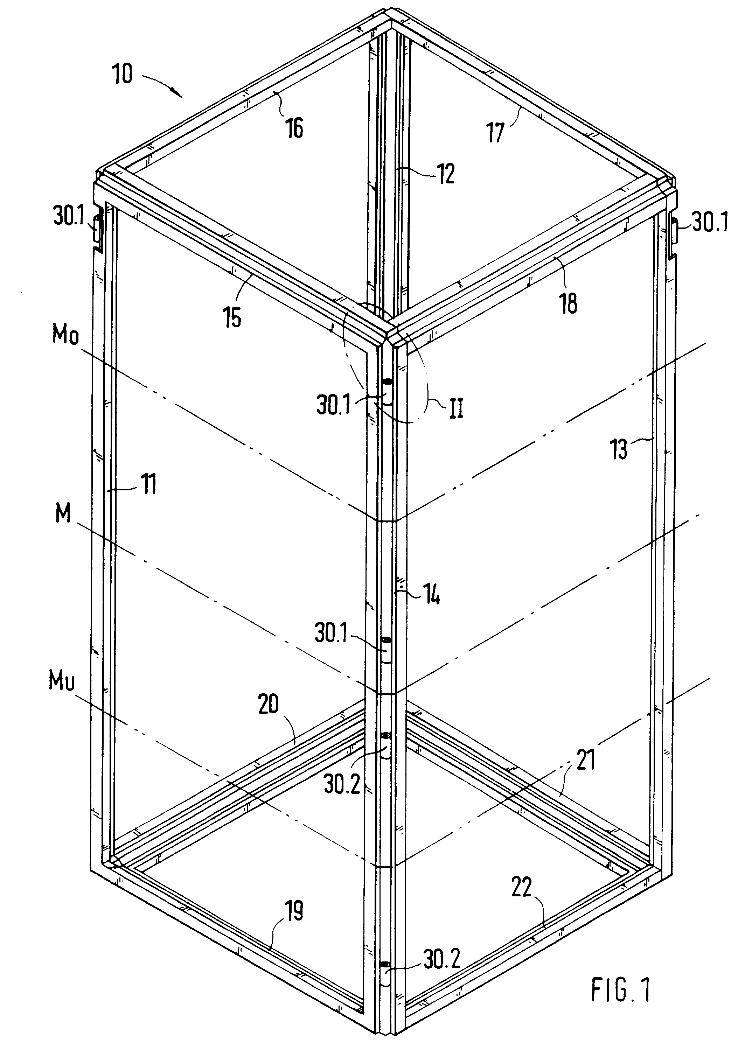

Das Rahmengestell 10 nach Fig. 1 wird aus den Rahmenschenkeln 11 bis 22 zusammengesetzt, wobei vorzugsweise Profilabschnitte gleichen Querschnitts verwendet werden. Diese Rahmenschenkel können als offenes oder geschlossenes Hohlprofil ausgebildet sein und werden in den Eckbereichen mittels Eckverbinder in bekannter Weise miteinander verbunden. Bei dem Rahmengestell 10 nach Fig. 1 können die Rahmenschenkel 11, 14, 15 und 19 auch zu einem unlösbaren Rahmen verbunden sein. Dasselbe gilt für die Rahmenschenkel 12, 13, 17 und 21. Die Rahmen können jedoch auch aus den vier seitlichen Rahmenschenkeln 11, 12, 16 und 20 bzw. 13, 14, 18 und 22 gebildet werden. Die beiden Rahmen werden dann über vier Verbindungsstreben 16, 18, 20 und 22 bzw. 15, 17, 19 und 21 miteinander verbunden.

Schließlich können auch die oberen bzw. unteren vier Rahmenschenkel 15,16, 17 und 18 bzw. 19, 20, 21 und 22 zu festen Rahmen verbunden sein, so daß die vier vertikalen Rahmenschenkel 11 bis 14 die Verbindung der beiden Rahmen übernehmen. Auf nach innen gekehrten Profilseiten können die Rahmenschenkel 11 bis 22 mit Reihen von Befestigungsaufnahmen versehen sein, damit in das Rahmengestell 10 Montagechassis, Befestigungsschienen, Einbauten und dgl. eingebaut werden können.

In Fig. 1 ist die horizontale Mittelebene M eingezeichnet, die die vertikalen Rahmenschenkel 11 bis 14 in zwei gleich lange Abschnitte unterteilt. Die obere Schrankhälfte wird durch die horizontale Mittelebene Mo und die untere Schrankhälfte durch die horizontale Mittelebene Mu in wiederum zwei gleiche Abschnitte unterteilt. Jeder vertikale Rahmenschenkel 11 bis 14 trägt nun zwei Paare von Anschlußelementen 30.1 und 30.2. Die Paare von Anschlußelementen 30.1 und 30.2 sind symmetrisch zur Mittelebene Mo angeordnet. Die Paare von Anschlußelementen 30.1 und 30.2 sind in den zugeordneten Schrankhälften wiederum zu den Mittelebenen Mo und Mu der Schrankhälften angeordnet. Ein Türelement, das sich über die gesamte Höhe des Schaltschrankes erstreckt, kann alle vier Anschlußelemente 30.1 und 30.2 für die Scharnier- bzw. Schließseite verwenden, wie noch gezeigt wird.

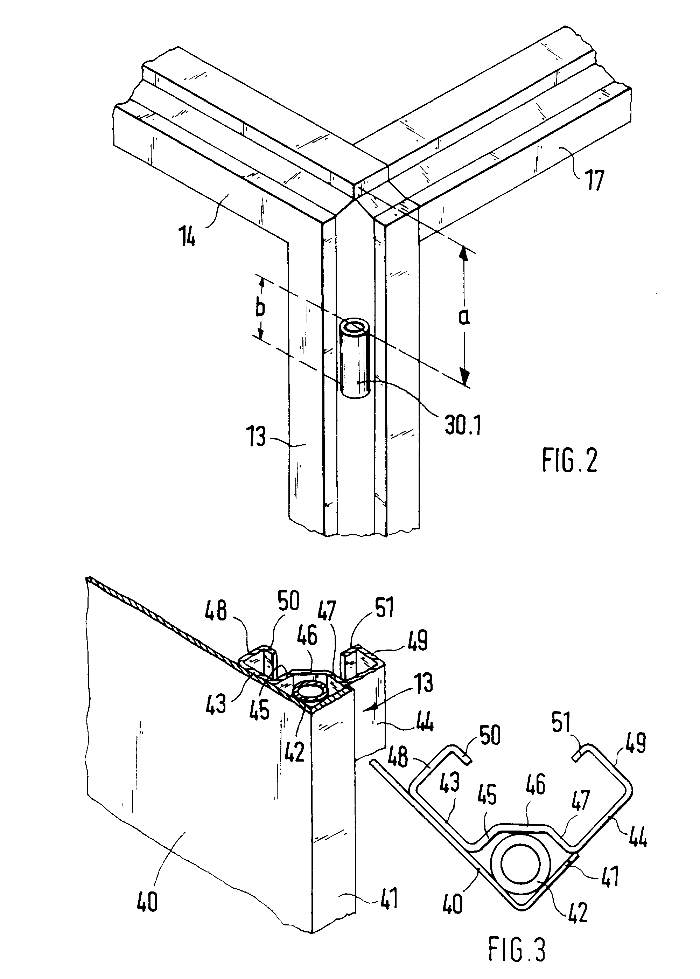

Bei dem Ausführungsbeispiel sind die Rahmenschenkel 11 bis 22 als offene Hohlprofilabschnitte ausgebildet, wie der Fig. 3 zu entnehmen ist. Dabei sind die Außenkanten der Rahmenschenkel mittels der Profileckabschnitte 46 abgeschrägt. Dieser Profileckabschnitt 46 geht über Übergangsabschnitte 45 und 47 in die Außenseiten-Profilabschnitte 43 und 44 über. Diese Übergangsabschnitte 45 und 47 stehen vorzugsweise senkrecht zu den anschließenden Außenseiten-Profilabschnitten 43 und 44. Die Außenseiten-Profilabschnitte 43 und 44 stehen im rechten Winkel zueinander. Auf diese Weise entsteht im Außeneckbereich der Rahmenschenkel 11 bis 22 eine durchgehende, axiale Aufnahme, die Platz für die Anschlußelemente 30.1 und 30.2 bieten. Die Anschlußelemente 30.1 und 30.2 werden so ausgelegt, daß sie mit den Außenseiten-Profilabschnitten 43 und 44 bündig abschließen.

Wie die Fig. 2 zeigt, werden Anschlußelemente 30.1 und 30.2 verwendet, die eine axiale Länge b aufweisen und im Abstand a von der Ober- bzw. Unterseite des Schaltschrankes an den vertikalen Rahmenschenkeln 11 bis 14 angebracht werden. Diesen Abstand a halten die jeweils anderen Anschlußelemente 30.1 und 30.2 von der Mittelebene M ein, wie aus Fig. 1 zu ersehen ist.

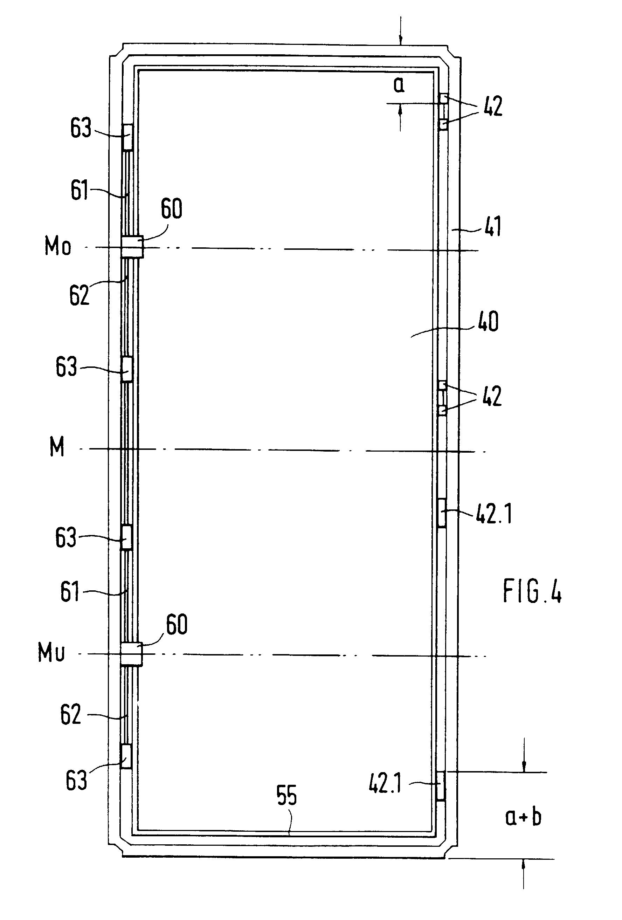

Das Türelement 40 nach Fig. 4 ist so ausgelegt, daß es die Schrankseite vollständig abdeckt. Auf der Innenseite des Türelementes 40, das mit einem abgebogenen Rand 41 versehen ist, sind im Bereich der Schließseite vier Scharnierelemente angebracht, die auf die vier Anschlußelemente 30.1 und 30.2 ausgerichtet sind. Wie das Scharnierelement 42 zeigt, kann es als Doppelhülse ausgebildet sein, bei der die beiden Hülsen beabstandet sind und ein Anschlußelement 30 mit der Abmessung b aufnehmen können. Die Scharnierelemente können auch als einzelne Hülse asugebildet sein, wie die Scharnierelemente 42.1 zeigen. Die Ausrichtung dieser Scharnierelemente 42 kann so gewählt werden, daß sie sich an eine der Stirnseiten eines Anschlußelementes 30.1 oder 30.2 anschließen. Die Anschlußelemente 30.1 und 30.2 sowie die Scharnierelemente 42 und 42.1 weisen eine gleich große Aufnahme auf, in die ein Scharnierbolzen eingesetzt werden kann. Das Türelement 40 ist daher an vier Stellen an einem vertikalen Rahmenschenkel 11 bis 14 anlenkbar.

Im Bereich der Schließseite trägt die Innenseite des Türelementes 40 Schließelemente 63, die sich an die einander zugekehrten Stirnseiten der Paare von Anschlußelementen 30.1 oder 30.2 eines Rahmenschenkels anschließen, wenn das Türelement 40 geschlossen wird. Die obere Hälfte des Türelementes 40 trägt einen ersten Schubstangenverschluß mit dem Verschluß 60 und den beiden Schubstangen 61 und 62, deren ende in den zugeordneten Schließelementen 63 geführt sind. Wird der Verschluß in die Schließstellung gebracht, dann werden die Schubstangen 61 und 62 in die Schließelemente 63 eingeführt.

In der unteren Schrankhälfte wird das Türelement 40 über einen weiteren Schubstangenverschluß mit dem zugekehrten vertikalen Rahmenschenkel verbunden. Da das Türelement 40 symmetrisch zur Mittelebene M ausgebildet ist, kann es sowohl links als auch rechts angeschlagen werden. Dazu muß es lediglich um 180° verdreht werden. Dabei ist es vorzugsweise mit einheitlichen Scharnierelementen 42 oder 42.1 versehen. Das Türelement 40 kann außerhalb der Scharnierelemente 42 bzw. 42.1 und des Schubstangenverschlusses mit einem Versteifungs- und Montagerahmen 55 versteift werden. Im Ausführungsbeispiel bilden die Schubstangen 61 und 62 die Gegenschließelemente.

Ein Türelement 40 kann in gleicher Weise auch für den Verschluß der jeweils gegenüberliegenden Seite des Rahmengestelles 10 verwendet werden. So kann ein Türelement 40 z.B. die Vorder- oder die Rückseite des Rahmengestelles 10 verschließen. Es können zum Verschluß der Vorder- und Rückseite des Rahmengestelles 10 auch zwei gleiche Türelemente 40 in frei wählbarer Anschlagart verwendet werden. Anstelle der Vorder- und Rückseite des Rahmengestelles können auch die beiden übrigen Seiten des Rahmengestelles mit einem oder zwei Türelementen entsprechender Abmessung verschlossen werden. Die Anbringung der Schließelemente 63 und der Scharnierelemente 42 bzw. 42.1 ist stets auf die Anordnung der Anschlußelemente 30.1 bzw. 30.2 an den vertikalen Rahmenschenkeln 11 bis 14 abzustimmen.

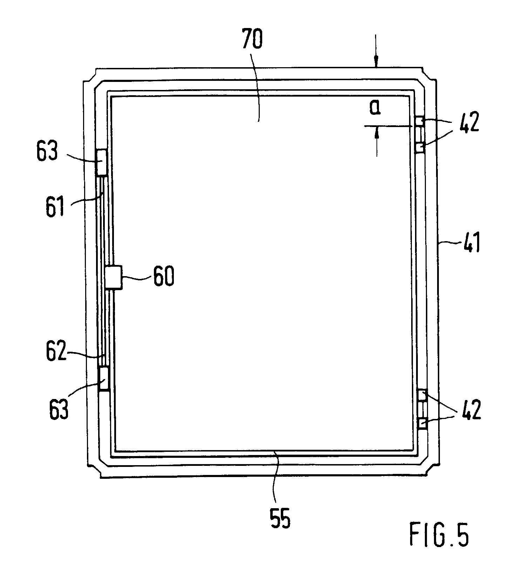

Wie Fig. 5 zeigt, kann ein kleines Türelement 70 auch zum Verschluß der oberen oder unteren Schrankhälfte verwendet werden. Die Scharnierelemente 42 auf der Scharnierseite sind dem Abstand a und der Länge b entsprechend angeordnet und so auf das Paar der Anschlußelemente 30.1 oder 30.2 ausgerichtet, daß das Türelement 70 an den vertikalen Rahmenschenkeln 11 bis 14 angelenkt werden kann. Auf der Schließseite sind die Schließelemente 63, die Schubstangen 61 und 62 sowie der Verschluß des Schubstangenschlosses auf das Paar von Anschlußelementen 30.1 oder 30.2 ausgerichtet, daß die Schubstangen 61 und 62 als Schließbolzen in die zugekehrten Anschlußelemente 30.1 oder 30.2 eines vertikalen Rahmenschenkels 11 bis 14 eingeführt werden können. An einer Schrankseite lassen sich daher zwei Türelemente 70 übereinander anordnen und unabhängig voneinander schließen und öffnen. Auch das kleinere Türelement 70 ist auf seiner Innenseite mit einem Verstärkungs- und Montagerahmen 55 versteift.

## Patentansprüche

1. Schaltschrank mit Türelementen (40), bei dem die Türelemente mittels Scharnierelementen und Verschlußelementen an zwei benachbarten Seiten anlenkbar, verschließbar und wieder freigebbar sind, wobei die Seiten symmetrisch zur Mitte ihrer Längsabmessung mindestens zwei hülsenförmige Anschlußelemente (30.1, 30.2) tragen, die sowohl als Scharnierelement als auch als Verschlußelement verwendbar sind, und wobei die Türelemente auf ihren Innenseiten symmetrisch zur Mittelachse auf der Anlenkseite jeweils auf die Anschlußelemente ausgerichtete Scharnierelemente (42) für Scharnierbolzen und auf der Schließseite jeweils auf die Anschlußelemente ausgerichtete Gegenschließelemente (63) aufweisen,
dadurch gekennzeichnet,
daß er ein aus Rahmenschenkeln (11 bis 22) zusammengesetztes Rahmengestell (10) aufweist,
daß die Außenkanten der Rahmenschenkel (11 bis 22) mittels geneigter Profileckabschnitte (46) freie Außeneckbereiche bilden,
daß die Profileckabschnitte (46) im stumpfen Winkel zu den aufeinanderstoßenden Außenseiten-Profilabschnitten (43,44) der Rahmenschenkel (11 bis 22) stehen,
daß an den geneigten Profileckabschnitten (46) aller vertikalen Rahmenschenkel (11 bis 14) symmetrisch zur horizontalen Mittelebene (M) des Schaltschrankes Paare von Anschlußelementen (30.1, 30.2) angebracht sind, und
daß die beiden Anschlußelemente (30.1, 30.2) der Paare jeweils wieder symmetrisch zu den Mittelebenen (Mo, Mu) der oberen und unteren Schrankhälfte an den vertikalen Rahmenschenkel (11 bis 14) angeordnet sind.

2. Schaltschrank nach Anspruch 1,
dadurch gekennzeichnet,
daß die hülsenförmigen Anschlußelemente (30.1, 30.2) der vertikalen Rahmenschenkel (11 bis 14) eine axiale Abmessung (b) aufweisen und in einem Abstand (a) von der oberen und unteren Seite des Schaltschrankes und der horizontalen Mittelebene (M) des Schaltschrankes angebracht sind.

3. Schaltschrank nach Anspruch 1 oder 2,
dadurch gekennzeichnet,
daß die Scharnierelemente (42) an den Türelementen (40,70) als axial beabstandete Doppelhülsen ausgebildet sind, deren Aufnahmen für Scharnierbolzen den Aufnahmen der als Anschlußelemente (30.1; 30.2) dienenden Hülsen der vertikalen Rahmenschenkel (11 bis 14) entsprechen und zwischen den beiden Hülsen der Scharnierelemente (42) ein Anschlußelement (30.1; 30.2) eines vertikalen Rahmenschenkels (11 bis 14) aufnehmen.

4. Schaltschrank nach Anspruch 1 oder 2,
dadurch gekennzeichnet,
daß die Scharnierelemente (42.1) eines Türelementes (40,70) als Hülsen ausgebildet sind, die sich an die einander zugekehrten oder abgekehrten Stirnseiten der beiden als Hülsen ausgebildeten Anschlußelemente (30.1; 30.2) eines vertikalen Rahmenschenkel (11 bis 14) anschließen und Aufnahmen für Scharnierbolzen bilden, die den Aufnahmen der Anschlußelemente (30.1; 30.2) der vertikalen Rahmenschenkel (11 bis 14) entsprechen.

5. Schaltschrank nach einem der Ansprüche 1 bis 4,
dadurch gekennzeichnet,
daß die Gegenschließelemente (61,62) der Türelemente (40,70) als Verschlußbolzen ausgebildet sind, die in auf der Innenseite des Türelemente (40,70) festgelegten Hülsen (63) verstellbar geführt und in die als Schließaufnahmen dienenden Anschlußelemente (30.1; 30.2) der vertikalen Rahmenschenkel (11 bis 14) einführbar und aus diesem wieder herausführbar sind.

6. Schaltschrank nach Anspruch 5,
dadurch gekennzeichnet,
daß die als Verschlußbolzen ausgebildeten Gegenschließelemente (61,62) Teile von Schubstangen eines Schubstangenverschlusses und mittels eines Schubstangenschlosses (60) gegenläufig verstellbar sind.

7. Schaltschrank nach einem der Ansprüche 1 bis 6,
dadurch gekennzeichnet,
daß die Profileckabschnitte (46) der Rahmenschenkel (11 bis 22) im Winkel von 135° zu den beiden aufeinanderstoßenden, senkrecht zueinander stehenden Außenseiten-Profilabschnitten (43,44) stehen und daß die Rahmenschenkel (11 bis 22) vorzugsweise als offene oder geschlossene Hohlprofilabschnitte ausgebildet sind.

8. Schaltschrank nach einem der Ansprüche 1 bis 7,
dadurch gekennzeichnet,
daß die Profileckabschnitte (46) der Rahmenschenkel (11 bis 22) mittels Übergangsabschnitten (45,47) in die Außenseiten-Profilabschnitte (43,44) übergehen, wobei die Übergangsabschnitte (45,47) vorzugsweise senkrecht zu den Außenseiten-Profilabschnitten (43,44) stehen.

9. Schaltschrank nach einem der Ansprüche 1 bis 8,
dadurch gekennzeichnet,
daß die Anschlußelemente (30.1; 30.2) der vertikalen Rahmenschenkel (11 bis 14) bündig mit den Außenseiten-Profilabschnitten (43,44) abschließen.

10. Schaltschrank nach einem der Ansprüche 1 bis 9,
dadurch gekennzeichnet,
daß die Türelemente (40,70) mit einem abgekanteten Rand (41) versehen sind, und
daß die Scharnierelemente (42) und die Gegenschließelemente (61,62) der Türelemente (40,70) in den freien Außeneckbereichen der vertikalen Rahmenschenkel (11 bis 14) angeordnet oder daran aufgenommen werden.

11. Schaltschrank nach einem der Ansprüche 1 bis 10,
dadurch gekennzeichnet,
daß das Türelement (40) sich über die gesamte Höhe des Schaltschrankes erstreckt und auf der Scharnierseite auf die beiden Paare von Anschlußelementen (30.1; 30.2) der vertikalen Rahmenschenkel (11 bis 14) ausgerichtete scharnierelemente (42, 42.1) trägt.

12. Schaltschrank nach Anspruch 11,
dadurch gekennzeichnet,
daß die Anschlußelemente (30.1; 30.2) eines der Schließseite des Türelementes (40) zugekehrten, vertikalen Rahmenschenkels (11 bis 14) paarweise als Aufnahmen für die Schubstangen von zwei Schubstangenverschlüssen verwendet sind, wobei der eine Schubstangenverschluß dem oberen Paar von Anschlußelementen (30.1) und der andere Schubstangenverschluß dem unteren Paar von Anschlußelementen (30.2) zugeordnet sind.

13. Schaltschrank nach einem Ansprüche 1 bis 10,
dadurch gekennzeichnet,
daß die Türelemente (70) sich über die obere und untere Hälfte der Höhe des Schaltschrankes erstrecken und die auf die oberen Paare von Anschlußelemente (30.1) sowie die unteren Paare (30.2) benachbarter, vertikaler Rahmenschenkel (11 bis 14) ausgerichteten Schließelemente (63) und Scharnierelemente (42) sowie einen Schubstangenverschluß tragen.

## Claims

1. Switchgear cabinet having door members (40) and in which the door members may be hinged on, locked and released again by means of hinge members and locking members on two adjacent sides, the sides carrying, symmetrically with respect to the centre of their longitudinal dimension, at least two sleeve-shaped connection members (30.1, 30.2) which may be used both as hinge members and as locking members, and the door members having on their inner sides, symmetrically with respect to the centre line on the hinge side, hinge members (42) for hinge pins, which members are aligned with the connection members, and the door members having on the locking side counter-locking members (63) respectively aligned with the connection members,
**characterised in that**
said cabinet has a framework (10) composed of frame members (11 to 22),
in that the outer edges of the frame members (11 to 22) form free outer corner regions by means of inclined profile corner portions,
in that the profile corner portions (46) lie at an obtuse angle to the outer side profile sections (43,44), which abut against one another, of the frame members (11 to 22),
in that, to the inclined profile corner portions (46) of all the vertical frame members (11 to 14), pairs of connection members (30.1, 30.2) are attached, symmetrically with respect to the horizontal centre plane (M) of the switchgear cabinet, and
in that the two connection members (30.1, 30.2) of the pairs are disposed, in each case again symmetrically with respect to the centre planes (Mo, Mu) of the upper and lower cabinet halves, on the vertical frame members (11 to 14).

2. Switchgear cabinet according to claim 1,
**characterised in that**
the sleeve-shaped connection members (30.1, 30.2) of the vertical frame members (11 to 14) have an axial dimension (b) and are attached at a spacing (a) from the upper and lower sides of the switchgear cabinet and from the horizontal centre plane (M) of the switchgear cabinet.

3. Switchgear cabinet according to claim 1 or 2,
**characterised in that**
the hinge members (42) are configured on the door members (40,70) as axially spaced double bushes whose receiving means for hinge pins correspond to the receiving means of the sleeves, serving as connection members (30.1; 30.2), of the vertical frame members (11 to 14), and receive between the two sleeves of the hinge members (42) a connection member (30.1; 30.2) of a vertical frame member (11 to 14).

4. Switchgear cabinet according to claim 1 or 2,
**characterised in that**
the hinge members (42.1) of a door member (40,70) are configured as sleeves which communicate with the front sides, facing or remote from one another, of the two connection members (30.1; 30.2) configured as sleeves of a vertical frame member (11 to 14) and form receiving means for hinge pins which correspond to the receiving means of the connection members (30.1; 30.2) of the vertical frame members (11 to 14).

5. Switchgear cabinet according to one of claims 1 to 4,
**characterised in that**
the counter-locking members (61,62) of the door members (40,70) are configured as locking bars, which are guided in an adjustable manner in sleeves (63) secured to the inner side of the door members (40,70) and may be led into the connection members (30.1; 30.2) serving as locking receiving means of the vertical frame members (11 to 14) and may be guided out of the latter again.

6. Switchgear cabinet according to claim 5,
**characterised in that**
the counter-locking members (61,62) configured as locking bars are parts of slide rods of a slide rod closure and may be adjusted in opposite directions by means of a slide rod lock (60).

7. Switchgear cabinet according to one of claims 1 to 5,
**characterised in that**
the profile corner portions (46) of the frame members (11 to 22) lie at an angle of 135° to the two outer sides profile sections (43,44) which abut against one another and are perpendicular to one another, and in that the frame members (11 to 22) are preferably configured as open or closed hollow profile sections.

8. Switchgear cabinet according to one of claims 1 to 7,
**characterised in that**
the profile corner portions (46) of the frame members (11 to 22) merge via transitional portions (45,47) into the outer sides profile sections (43,44), the transitional portions (45,47) standing preferably perpendicular to the outer sides profile portions (43,44).

9. Switchgear cabinet according to one of claims 1 to 8,
**characterised in that**
the connection members (30.1; 30.2) of the vertical frame members (11) terminate flush with the outer sides profile sections (43,44).

10. Switchgear cabinet according to one of claims 1 to 9,
**characterised in that**
the door members (40,70) are provided with a bent-over border (41), and
in that the hinge members (42) and the counter-locking members (61,62) of the door members (40,70) are disposed in the free outer corner regions of the vertical frame members (11 to 14) or received thereon.

11. Switchgear cabinet according to one of claims 1 to 10,
**characterised in that**
the door member (40) extends over the whole height of the switchgear cabinet and carries on the hinge side hinge members (42,42.1) aligned with the two pairs of connection members (30.1; 30.2) of the vertical frame members (11 to 14).

12. Switchgear cabinet according to claim 11,
**characterised in that**
the connection members (30.1; 30.2) of one of the vertical frame members facing the locking side of the door member (40) are used in pairs as receiving means for the slide rods of two slide rod closures, the one slide rod closure being associated with the upper pair of connection members (30.1) and the other slide rod closure being associated with the lower pair of connection members (30.2).

13. Switchgear cabinet according to one of claims 1 to 10,
**characterised in that**
the door members (70) extend beyond the upper and lower halves of the height of the switchgear cabinet and carry locking members (63) and hinge members (42) aligned with the upper pairs of connection members (30.1) as well as the lower pairs (30.2) of adjacent, vertical frame members (11 to 14), as well as a slide rod closure.

## Revendications

1. Armoire de distribution munie d'éléments de porte (40), dans laquelle les éléments de porte peuvent, au moyen d'éléments de charnière et d'éléments de fermeture, être articulés, être fermés et de nouveau être ouverts sur deux côtés verticaux voisins, où les côtés présentent symétriquement à leur médiane verticale au moins deux éléments de connexion (30.1, 30.2) en forme de douille, qui peuvent faire fonction tant d'éléments de charnière qu'également d'éléments de fermeture, et où les éléments de porte présentent sur leurs faces intérieures et symétriquement à l'axe médian, côté articulation et en alignement avec les éléments de connexion, des éléments de charnière (42) pour de boulons de charnière et présentent, du côté fermeture, des éléments de fermeture antagonistes (63) en alignement avec des éléments de connexion,
caractérisée
en ce qu'elle présente une ossature d'encadrement (10) composée de branches d'encadrement (11 à 22),
en ce que les arêtes extérieures des branches d'encadrement (11 à 22) constituent, par des tronçons de profilé d'angle (46), des zones d'angle extérieures,
en ce que les tronçons de profilé d'angle (46) forment un angle obtus avec les tronçons de profilé côté extérieur (43, 44) des branches d'encadrement (11 à 22),
en ce que sur les tronçons de profilé d'angle (46) de toutes les branches d'encadrement verticales (11 à 14) et symétriquement au plan médian horizontal (M) de l'armoire de distribution sont montées des paires d'éléments de connexion (30.1, 30.2), et
en ce que les deux éléments de connexion (30.1, 30.2) des paires sont à leur tour, symétriquement par rapport aux plans médians (Mo, Mu) de la moitié supérieure et de la moitié inférieure de la porte, disposés sur les branches d'encadrement verticales (11 à 14).

2. Armoire de distribution suivant la revendication 1,
caractérisée
en ce que les éléments de connexion en forme de douille (30.1, 30.2) des branches d'encadrement verticaux (11 à 14) ont une dimension axiale déterminée (b) et sont disposés à une distance (a) de la face supérieure et de la face inférieure de l'armoire de distribution et du plan médian horizontal (M) de l'armoire de distribution.

3. Armoire de distribution suivant la revendication 1 ou la revendication 2,
caractérisée
en ce que sur les éléments de porte (40, 70), les éléments de charnière (42) ont la forme de douilles doubles distancées axialement, dont les logements pour les boulons de charnière des douilles correspondent aux logements des douilles des branches d'encadrement verticales (11 à 14) servant d'éléments de connexion (30,1; 30.2) et reçoivent entre les deux douilles des éléments de charnière (42) un élément de connexion (30,1: 30,2) d'une branche d'encadrement verticale (11 à 14).

4. Armoire de distribution suivant la revendication 1 ou la revendication 2,
caractérisée
en ce que les éléments de charnière (42.1) d'un élément de porte (40, 70) ont la forme de douilles, qui se raccordent aux faces frontales orientées l'une vers l'autre ou non orientées l'une vers l'autre des deux éléments de connexion (30.1; 30.2) d'une branche d'encadrement verticale (11 à 14) et constituent des logements récepteurs pour des boulons de charnière, qui correspondent aux logements récepteurs des éléments de connexion (30.&; 30.2) des branches d'encadrement verticales (11 à 14).

5. Armoire de distribution suivant l'une quelconque des revendications de 1 à 4,
caractérisée
en ce que les éléments de fermeture antagonistes (61, 62) des éléments de porte (40, 70) ont la forme de boulons de fermeture qui sont guidés de manière réglable dans des douilles (63) fixées à la face intérieure des éléments de porte (40, 70) et qui peuvent être engagés dans les éléments de connexion (30.1 30.2) servant de récepteurs de fermeture des branches d'encadrement verticales (11 à 14), et qui peuvent ensuite en être extraits.

6. Armoire de distribution suivant la revendication 5,
caractérisée
en ce que les éléments de fermeture antagonistes (61, 62) en forme de boulons de fermeture sont des composants de d'une fermeture à targette et peuvent au moyen d'un bouton de targette (60) être déplacés en sens opposés.

7. Armoire de distribution suivant l'une quelconque des revendications de 1 à 6,
caractérisée
en ce que les tronçons d'angle profilés (46) des branches d'encadrement (11 à 24) forment un angle de 135° avec les tronçons profilés de face extérieure (43, 44) butant l'un contre l'autre et perpendiculaires l'un à l'autre, et en ce que les branches d'encadrement (11 à 22) ont de préférence la forme de tronçons profilés creux ouverts ou fermés.

8. Armoire de distribution suivant l'une quelconque des revendications de 1 à 7,
caractérisée
en ce que les tronçons profilés d'angle (46) des branches d'encadrement (11 à 22) se raccordent au moyen de tronçons de transition (45, 47) aux tronçons profilés de la face extérieure (43, 44), et en ce que les tronçons de transition (45, 47) sont de préférence perpendiculaires aux tronçons profilés de la face extérieure (43, 44).

9. Armoire de distribution suivant l'une quelconque des revendications de 1 à 8,
caractérisée
en ce que les éléments de connexion (30.1; 30.2) des branches d'encadrement verticales (11 à 14) se terminent à fleur des tronçons profilés de la face extérieure (43, 44).

10. Armoire de distribution suivant l'une quelconque des revendications de 1 à 9,
caractérisée
en ce que les éléments de porte (40, 70) sont dotés d'un bord coudé (41), et
en ce que les éléments de charnière (42) et les éléments de fermeture antagonistes (61, 62) des éléments de porte (40, 70) sont disposés dans les zones d'angle extérieures libres des branches d'encadrement verticales (11 à 14) ou bien y sont reçus.

11. Armoire de distribution suivant l'une quelconque des revendications de 1 à 10,
caractérisée
en ce que l'élément de porte (40) s'étend sur toute la hauteur de l'armoire de distribution et porte côté charnière des éléments de charnière (42, 42.1) dirigés sur les deux paires d'éléments de connexion (30.1; 30.2) des branches d'encadrement verticales (11 à 14).

12. Armoire de distribution suivant la revendication 11.
caractérisée
en ce que les éléments de connexion (30.1; 30.2) d'une branche d'encadrement verticale (11 à 14) orientée vers le côté fermeture de l'élément de porte (40) font fonction, par paires, de logements récepteurs pour les tringles de deux serrures à targette, où l'une des serrures à targette est associée à la paire supérieure d'éléments de connexion (30.1) et où l'autre serrure à targette est associée à la paire inférieure d'éléments de connexion (30.2).

13. Armoire de distribution suivant l'une quelconque des revendications de 1 à 10.
caractérisée
en ce que les éléments de connexion (70) s'étendent sur la moitié supérieure et inférieure de la hauteur de l'armoire de distribution et portent des éléments de fermeture (63) et des éléments de charnière (42) dirigés vers les paires supérieures d'éléments de connexion (30.1) ainsi que sur les paires inférieures (30.2) de branches d'encadrement verticaux voisins (11 à 14) ainsi qu'une serrure à targette.
